(19) Europäisches Patentamt
European Patent Office
Office européen des brevets

(11) **EP 4 368 590 A1**

(12) **EUROPEAN PATENT APPLICATION**
published in accordance with Art. 153(4) EPC

(43) Date of publication:
**15.05.2024 Bulletin 2024/20**

(21) Application number: **22852283.5**

(22) Date of filing: **04.08.2022**

(51) International Patent Classification (IPC):
**C03C 10/12** (2006.01)   **C03B 32/02** (2006.01)

(52) Cooperative Patent Classification (CPC):
**C03B 32/02; C03C 10/00**

(86) International application number:
**PCT/CN2022/110155**

(87) International publication number:
**WO 2023/011571 (09.02.2023 Gazette 2023/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.08.2021 CN 202110897039**

(71) Applicant: **Chongqing Aureavia Hi-tech Glass Co., Ltd**
**Chongqing 400714 (CN)**

(72) Inventors:
• **DENG, Shuang**
  **Chongqing 400714 (CN)**
• **HUANG, Hao**
  **Chongqing 400714 (CN)**
• **WANG, Yubo**
  **Chongqing 400714 (CN)**
• **TAN, Baoquan**
  **Chongqing 400714 (CN)**
• **HU, Wei**
  **Chongqing 400714 (CN)**

(74) Representative: **Croce, Valeria et al**
**Jacobacci & Partners S.p.A.**
**Via Senato, 8**
**20121 Milano (IT)**

(54) **TRANSPARENT MICROCRYSTALLINE GLASS, AND PREPARATION METHOD THEREFOR AND USE THEREOF**

(57)    A preparation method for transparent microcrystalline glass, and transparent microcrystalline glass and a use thereof. The preparation method comprises: (1) nucleating a glass raw sheet, (2) crystallizing the nucleated glass raw sheet, and (3) performing heat treatment on the crystallized glass sheet to obtain microcrystalline glass having an XRD diffraction peak height H that is greater than or equal to 870, wherein the content of lithium disilicate and petalite in the microcrystalline glass is 90-100%; the heat treatment is divided into a heating stage, a high-temperature stage, and a cooling stage; the heating stage is divided into n heating stages, the high-temperature stage is divided into k high-temperature stages, the cooling stage is divided into m cooling stages, k is an integer obtained by rounding (n+k+m)/3, and $6 \geq n+k+m \geq 30$; the maximum value of the constant temperature $T_{Ki}$ of the high-temperature stages is $T_{Kmax}$, and $T_{Kmax}=Tg+\Delta T_2$; and in the k high-temperature stages, a temperature difference between any two adjacent heat treatment stages is within the range of 5-50°C.

FIG. 1

EP 4 368 590 A1

## Description

## Technical Field

The present disclosure relates to the field of microcrystalline glass (i.e., glass-ceramic), and in particular, to transparent microcrystalline glass, and a preparation method therefor and a use thereof.

## Background Art

With the arrival of intelligent era of mobile phones, the mobile phones have become an indispensable communication tool in daily life. As mobile phone users grow year by year, in order to meet requirements of the mobile phone users and increase use experience of the users, the mobile phones are also updated, transformed and phased out at an ever-increasing rate. The mobile phone cover glass develops from the earliest 2D glass to 2.5D glass and then to nowaday 3D glass, which adds novelty to terminal products of the mobile phones in appearance, and meanwhile also can enhance the users' sense of touch experience.

The reason why glass can be used as a cover plate for mobile phones is not only due to its good mechanical performance, but also due to its high transparency. Common glass has no change in optical performance when being subjected to a heat treatment. However, the microcrystalline glass, composed of a glass phase and a crystalline phase, will produce large and small crystals inside during heat treatment. The crystalline phases contained in the microcrystalline glass in different crystalline states have certain differences. Studies have shown that a difference in refractive index between the crystalline phase and the glass phase is a main cause for deterioration of the optical performance of the microcrystalline glass. For lithium-aluminum-silicate (LAS) microcrystalline glass ($Li_2O$-$Al_2O_3$-$SiO_2$ glass-ceramic, $Li_2O$-$Al_2O_3$-$SiO_2$ system glass-ceramic), lithium silicate ($Li_2SiO_3$) and $\beta$-quartz ($\beta$-$SiO_2$) may deteriorate the optical performance of the microcrystalline glass, wherein lithium silicate ($Li_2SiO_3$) mainly appears in processes with low crystallinity and excessive crystallization, and $\beta$-quartz ($\beta$-$SiO_2$) mainly appears in processes with excessive crystallization.

Microcrystalline glass with different crystalline states may be obtained through different heat treatment processes, and the microcrystalline glass with different crystalline states has certain difference in optical performance. During the heat treatment, abnormal crystallization of the microcrystalline glass inevitably exists, that is, the situation that a glass sheet is whitish occurs.

Therefore, how to obtain transparent microcrystalline glass with an excellent optical performance from the heat treatment is of great significance, which not only can improve the quality of the microcrystalline glass, but also can improve the production yield of the microcrystalline glass, thereby reducing the production cost.

## Summary

For this purpose, the present disclosure aims at providing transparent microcrystalline glass, a preparation method therefor and a use thereof. For a crystallized glass raw sheet, the present disclosure, starting from a heat treatment process, obtains the microcrystalline glass with an XRD diffraction peak height H of ≥870 by controlling relevant process parameters. The prepared microcrystalline glass has an excellent optical performance, takes a short period of time, and has a high production yield and high production efficiency.

In the first aspect, the present disclosure provides a preparation method for transparent microcrystalline glass, wherein the method may include the following steps:

(1) performing nucleation on a glass raw sheet;

(2) performing crystallization on the nucleated glass raw sheet; and

(3) performing a heat treatment on the crystallized glass sheet, so as to obtain the microcrystalline glass with an XRD diffraction peak height H of ≥870,

where the heat treatment may be divided into a heating stage, a high-temperature stage and a cooling stage, wherein the heating stage is divided into n heating stages, the high-temperature stage is divided into k high-temperature stages, and the cooling stage is divided into m cooling stages, where the k is an integer obtained by rounding $(n+k+m)/3$, and $6 \geq n+k+m \geq 30$;

each high-temperature stage may have a constant temperature $T_{Ki}$, where i=1, 2, 3...;

a maximum value of the constant temperature $T_{Ki}$ in the k high-temperature stages is $T_{Kmax}$, and $T_{Kmax}=T_g+\Delta T_2$,

where the $T_g$ is a glass transition point temperature of the glass raw sheet,

wherein the $\Delta T_2$ may satisfy the following formula:

$H=(965.522\pm21.205)+(0.816\pm1.876)|(Tg+\Delta T_2)-(715.212\pm5.120)|^\wedge(1.465\pm0.566)$; and

in the k high-temperature stages, a temperature difference between any two adjacent heat treatment stages is within a range of 5~50 °C.

In some embodiments, a temperature of the nucleation may be $T_g$+10 °C~$T_g$+80 °C, and a duration of the nucleation is 120~360 min.

In some embodiments, a temperature of the crystallization may be $T_g$+$\Delta T_1$, and a duration of the crystallization is 30~150 min, where 100 °C$\leq\Delta T_1\leq$150 °C.

In some embodiments, the XRD diffraction peak height H of the microcrystalline glass may be 960~1150.

In some embodiments, processing durations of the k high-temperature stages, the n heating stages and the m cooling stages are each independently selected from 10~90 s.

In some embodiments, in the n heating stages, a temperature difference between any two adjacent heat treatment stages is within a range of 10~150 °C; and optionally, in the m cooling stages, a temperature difference between any two adjacent heat treatment stages is within a range of 10~150 °C.

In some embodiments, in the k high-temperature stages, a temperature difference between any two adjacent heat treatment stages is within a range of 5~30 °C, and preferably, the temperature difference is within a range of 10~20 °C.

In some embodiments, the glass raw sheet may be lithium-aluminum-silicate glass (lithium-aluminum-silicate system glass).

In some embodiments, the glass raw sheet may contain the following components in mol%:

| | |
|---|---|
| $SiO_2$ | 65~72 |
| $Al_2O_3$ | 3~7 |
| $ZrO_2$ | 0.5~5 |
| $Li_2O$ | 15~25 |
| $Na_2O$ | 0~2 |
| $P_2O_5$ | 0.5~2 |
| $B_2O_3$ | 0~2 |
| MgO | 0~3 |
| ZnO | 0~3. |

In the second aspect, the present disclosure provides microcrystalline glass prepared by the above method, wherein an XRD diffraction peak height H of the microcrystalline glass is greater than or equal to 870, preferably 960-1150, and further preferably 980~1132.

Preferably, b value of the microcrystalline glass is less than or equal to 0.4.

Preferably, in the microcrystalline glass, a content of lithium disilicate and petalite is 90-100%.

Preferably, in the microcrystalline glass, a content of crystalline phases of lithium silicate and β-quartz is 0-10%, wherein preferably, the content of the crystalline phases of lithium silicate and β-quartz is less than or equal to 5; and further preferably, the content of the crystalline phases of lithium silicate and β-quartz is 0.

In the third aspect, the present disclosure provides a use of the microcrystalline glass prepared by the above method, wherein the microcrystalline glass is used as any one of a mobile phone cover plate, a tablet computer cover plate, a watch cover plate, and an automobile display cover plate.

The present disclosure at least has the following beneficial technical effects.

The present disclosure, starting from the heat treatment process, divides the heat treatment into three stages, namely, the heating stage, the high-temperature stage and the cooling stage, and obtains the microcrystalline glass with the XRD diffraction peak height H of ≥870 by controlling the maximum value of the temperature in the high-temperature stages, $T_{max}$=Tg+$\Delta T_2$, where the $\Delta T_2$ satisfies: $H=(965.522\pm21.205)+(0.816\pm1.876)|(Tg+\Delta T_2)-(715.212\pm5.120)|^\wedge(1.465\pm0.566)$. The microcrystalline glass prepared through this process has a good optical performance, and particularly when controlling the diffraction peak height H of the obtained microcrystalline glass to be 960-1150, the microcrystalline glass with the b value of ≤0.4 may be obtained. Moreover, this process improves the production yield of cover plates of the transparent microcrystalline glass, takes a short period of time, and has high production efficiency.

**Brief Description of Drawing**

In order to more clearly illustrate technical solutions of examples of the present disclosure, a drawing that needs to be used in the related art and examples of the present disclosure is described briefly below. It should be understood that the drawing merely shows some examples of the present disclosure, and therefore should not be considered as a limitation to the scope. Those ordinarily skilled in the art could also obtain other relevant drawings according to the drawing without using any inventive efforts.

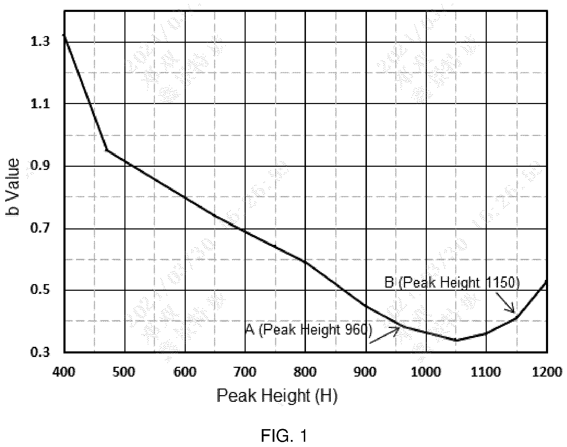

FIG. 1 - a graph of changes in relationship between an XRD highest diffraction peak height (H) and b value of lithium-aluminum-silicate microcrystalline glass after heat treatment.

**Detailed Description of Embodiments**

In order to make objectives, technical solutions and advantages of the examples of the present disclosure clearer, the technical solutions in the examples of the present disclosure will be described clearly and completely below. If no specific conditions are specified in the examples, they are carried out under normal conditions or conditions recommended by manufacturers. If manufacturers of reagents or apparatuses used are not specified, they are all commercially available conventional products.

Transparent microcrystalline glass, and a preparation method therefor and a use thereof in the examples of the present disclosure are specifically illustrated below.

The present disclosure provides a preparation method for transparent microcrystalline glass, wherein the method includes the following steps:

(1) performing nucleation on a glass raw sheet;

(2) performing crystallization on the nucleated glass raw sheet; and

(3) performing a heat treatment on the crystallized glass sheet, so as to obtain microcrystalline glass with an XRD diffraction peak height H of $\geq 870$, wherein specifically, the diffraction peak height H may be 900, 920, 940, 960, 980, 1000, 1020, 1040, 1060, 1080, 1100, 1120, 1140, 1160, 1170, etc., and preferably, the diffraction peak height H is 960-1150; and more preferably, the diffraction peak height H is 980~1132.

The heat treatment is divided into a heating stage, a high-temperature stage and a cooling stage. The heating stage is divided into n heating stages, which are $N_1$, $N_2$, $N_3$...$N_n$, respectively. The high-temperature stage is divided into k high-temperature stages, which are $K_1$, $K_2$, $K_3$...$K_k$, respectively. The cooling stage is divided into m cooling stages, which are $M_1$, $M_2$, $M_3$...$M_m$, respectively. The k is an integer obtained by rounding $(n+k+m)/3$, and $6 \leq n+k+m \leq 30$.

During the heat treatment process, the heating stage and the cooling stage play a role of pre-heating and cooling the microcrystalline glass, because if the glass is directly placed in a high-temperature environment from a low-temperature environment or placed in a low-temperature environment from a high-temperature environment, the glass is likely to break due to uneven cold and heat of the glass itself caused thereby. The high-temperature stage belongs to a secondary crystallization stage of the microcrystalline glass, and after the k stages of high-temperature heat treatment, crystal growth in the microcrystalline glass is more mature, which is manifested in increased crystallinity of the microcrystalline glass. The inventor found through experiments that, for microcrystalline glass that is easy to experience devitrification, such as lithium-aluminum-silicate microcrystalline glass, a total number of stages of the heat treatment process may be small, and when $6 \leq n+k+m \leq 15$, microcrystalline glass with crystallinity of greater than 90% can be obtained; and for microcrystalline glass that is difficult to experience devitrification, such as spinel microcrystalline glass, the number of stages of the heat treatment process may be appropriately increased, that is, when $15 \leq n+k+m \leq 30$, microcrystalline glass with crystallinity of greater than 90% may be obtained; but when the number of stages of the heat treatment is greater than 30, as a state of obtained microcrystalline glass is almost the same as that of microcrystalline glass obtained when the number of stages of the heat treatment process is 30, it may be considered in this case that the precipitated crystal of the microcrystalline glass is already in a saturated state when the number of stages of the heat treatment process is increased to 30, and therefore, the total number of the stages of the heat treatment process is controlled within the range of $6 \leq n+k+m \leq 30$ from efficiency and cost considerations.

Specifically, n+k+m may be 7, 8, 9, 10, 12, 14, 16, 18, 20, 21, 22, 25, 27, 28, etc. Preferably, the number of the heating stages and the number of the cooling stages are equal or similar. For example, when n+k+m=9, there are 9/3=3 high-temperature stages, and 3 heating stages and 3 cooling stages, respectively; when n+k+m=10, by rounding 10/3 to obtain an integer 3, there are 3 high-temperature stages, and there may be 3 heating stages and 4 cooling stages, or 4 heating stages and 3 cooling stages; and when n+k+m=11, by rounding 11/3 to obtain an integer 3, there are 3 high-temperature stages, and there may be 4 heating stages and 4 cooling stages, respectively.

Each high-temperature stage has a constant temperature $T_{Ki}$, where i=1, 2, 3...;
a maximum value of the constant temperature $T_{Ki}$ in the k high-temperature stages is $T_{Kmax}$, and $T_{Kmax}=Tg+\Delta T_2$, where the $T_g$ is a glass transition point temperature of the glass raw sheet.

In the above, the $\Delta T_2$ satisfies the following formula:

$$H=(965.522\pm21.205)+(0.816\pm1.876)|(Tg+\Delta T_2)-(715.212\pm5.120)|^{\wedge}(1.465\pm0.566).$$

Moreover, in the k high-temperature stages, a temperature difference between any two adjacent heat treatment stages is within a range of 5~50 °C. Specifically, the temperature difference may be 8 °C, 10 °C, 15 °C, 18 °C, 20 °C, 25 °C, 30 °C, 35 °C, 40 °C, or 45 °C, etc., preferably, the temperature difference is within a range of 5~30 °C, and further preferably, the temperature difference is within a range of 10~20 °C.

In some embodiments, a temperature of the nucleation is $T_g+10\ °C\sim T_g+80\ °C$, and a duration of the nucleation is 120~360 min. Specifically, the temperature of the nucleation may be $T_g+20\ °C$, $T_g+30\ °C$, $T_g+40\ °C$, $T_g+50\ °C$, $T_g+60\ °C$, or $T_g+70\ °C$, etc.; and the duration of the nucleation is 130 min, 150 min, 180 min, 200 min, 240 min, 260 min, 300 min, 320 min or 340 min, etc.

In some embodiments, a temperature of the crystallization is $T_g+\Delta T_1$, and a duration of the crystallization is 30~150 min, where 100 °C$\leq\Delta T_1\leq$150 °C. Specifically, $\Delta T_1$ may be 110 °C, 115 °C, 120 °C, 125 °C, 130 °C, 135 °C, 140°C or 145 °C, etc.; and the duration of the crystallization may be 35 min, 40 min, 50 min, 60 min, 70 min, 80 min, 90 min, 100 min, 110 min, 120 min, 130 min or 140 min, etc.

The inventor found that, during the nucleation, crystallization and heat treatment of the glass, by setting different crystallization and heat treatment processes, the microcrystalline glass in different crystallization states may be obtained, and correspondingly, the XRD highest diffraction peak height of the microcrystalline glass also has a certain pattern of change.

During the crystallization and heat treatment, by adjusting the temperature $\Delta T_1$ during the crystallization treatment and the temperature $\Delta T_2$ in the high-temperature stage during the heat treatment, the microcrystalline glass with different XRD highest diffraction peak heights H may be obtained, and a relationship therebetween is as follows.

When the XRD highest diffraction peak height is less than 870:

$$H=-(0.23197\pm0.02596)\Delta T_{1^{\wedge}3}+(86.57095\pm9.6945)\Delta T_{1^{\wedge}2\_}(10724.28028\pm1205.81659)\Delta T_1+(441572.3243\pm49947.99012)$$

Formula I:

When the XRD highest diffraction peak height is greater than 870:

$$H=(965.522\pm21.205)+(0.816\pm1.876)|(Tg+\Delta T_2(-715.212\pm5.120)|^{\wedge}(1.465\pm0.566)$$

Formula II.

In the above, the highest diffraction peak height H of the glass obtained during the crystallization treatment is less than 870. In combination with Formula I, a specific range of the diffraction peak height H may be determined by adjusting the magnitude of relevant parameter $\Delta T_1$ during the crystallization process. In this case, the crystal growth of the microcrystalline glass is not yet mature, the crystallinity of the microcrystalline glass is low, and the crystallinity y is less than or equal to 70%, that is, the glass in this state has poor transparency.

In order to further improve the transparency of the glass, the heat treatment needs to be performed on the crystallized glass, so as to improve the crystallinity of the microcrystalline glass. As the crystallinity y of the microcrystalline glass is greater than or equal to 70%, the crystal growth of the microcrystalline glass also gradually tends to be mature, the corresponding XRD highest diffraction peak height also starts to rise, the highest diffraction peak height H in this case is greater than or equal to 870, and the glass in this state needs to be obtained by increasing the temperature of the heat treatment. In combination with Formula 2, a specific range of the diffraction peak height H may be determined by adjusting the magnitude of relevant temperature parameter $\Delta T_2$ in the high-temperature stage in the heat treatment process.

The inventor further found that the XRD highest diffraction peak height and b value of the microcrystalline glass have a certain pattern of change. FIG. 1 shows a graph of changes in relationship between the XRD highest diffraction peak height (H) and the b value of lithium-aluminum-silicate microcrystalline glass after heat treatment. In the graph, the XRD highest diffraction peak height of a microcrystalline glass sheet is taken as a horizontal coordinate, and the b value is taken as a vertical coordinate. When the XRD highest diffraction peak height is less than 870, the b value of the microcrystalline glass is greater than 0.4, and in this case, a principal crystalline phase contained in the glass includes lithium silicate ($Li_2SiO_3$) and petalite ($LiAlSi_4O_{10}$). However, when the XRD highest diffraction peak height is greater than 870, particularly when the peak height is 960 to 1150, the b value of the microcrystalline glass is less than or equal to 0.40, and in this case, the principal crystalline phase contained in the glass is lithium disilicate ($Li_2Si_2O_5$) and petalite ($LiAlSi_4O_{10}$), and meanwhile contains a small amount of lithium silicate ($Li_2SiO_3$) crystalline phase and a small amount of β-quartz β-$SiO_2$) crystalline phase (or no β-quartz β-$SiO_2$) crystalline phase). In the above, when the peak height H is 960, i.e., as shown by point A in the graph, the glass just reaches a state of complete crystallization, and in this case, the lithium silicate ($Li_2SiO_3$) crystalline phase is substantially completely converted into the lithium disilicate ($Li_2Si_2O_5$) crystalline phase (even if there is residual incompletely crystallized lithium silicate, a content thereof is small), and this point is a starting point of complete crystallization. When the peak height H reaches 1150, i.e., as shown by point B in the graph, the glass is still in a state of complete crystallization, and this point is an end point of the complete crystallization. When the XRD highest diffraction peak height is greater than 1150, i.e. the point B is passed, the b value will be greater than 0.40, and with the increasing of the peak height, the b value will continuously rise, and in this case, excessive crystallization occurs in the microcrystalline glass, and lithium silicate ($Li_2SiO_3$), β-quartz (β-$SiO_2$) and other impure phases generated again may appear, i.e., the principal crystalline phase contained in the glass is lithium disilicate ($Li_2Si_2O_5$) and petalite ($LiAlSi_4O_{10}$), and meanwhile a small amount of lithium silicate ($Li_2SiO_3$) crystalline phase and a small amount of β-quartz β-$SiO_2$) crystalline phase (or no β-quartz (β-$SiO_2$) crystalline phase) are contained.

Complete crystallization: in the microcrystalline glass, the lithium silicate ($Li_2SiO_3$) crystalline phase is completely converted into the lithium disilicate ($Li_2Si_2O_5$) crystalline phase, and there are no (or less) lithium silicate ($Li_2SiO_3$) crystalline phase, β-quartz (β-$SiO_2$) crystalline phase and other crystalline phases.

Excessive crystallization: the microcrystalline glass reaches the complete crystallization, and meanwhile lithium silicate ($Li_2SiO_3$), β-quartz (β-$SiO_2$) and other crystalline phases are generated.

b value: it is a yellow-blue value. The b value is measured for transmitted light, wherein when the b value is positive, it indicates that less blue light is transmitted, that is, more blue light is reflected, and a larger b value indicates bluer glass.

In the present disclosure, in combination with Formula II:
$H=(965.522\pm21.205)+(0.816\pm1.876)|(Tg+\Delta T_2)-(715.212\pm5.120)|^{\wedge}(1.465\pm0.566)$, by adjusting the value of the relevant process parameter $\Delta T_2$ of the high-temperature stage in the heat treatment process, a range of the XRD highest diffraction peak height of a cover plate of the microcrystalline glass after the heat treatment may be determined, and the peak height H thereof is made greater than 870, preferably within a range from 960 to 1150, thus the generation of crystalline phases of lithium silicate and β-quartz may be avoided to the greatest extent, so as to obtain a transparent microcrystalline glass cover plate with a good optical performance.

In some embodiments, processing durations of the k high-temperature stages, the n heating stages and the m cooling stages are each independently selected from 10~90 s. Specifically, the processing durations may be 15 s, 20 s, 25 s, 30 s, 35 s, 40 s, 45 s, 50 s, 55 s, 60 s, 65 s, 70 s, 75 s, 80 s or 85 s, etc. By controlling the duration of each stage, while controlling the diffraction peak height and obtaining the microcrystalline glass with a good optical performance, the production duration consumed may be shortened, and the production efficiency may be improved.

In some embodiments, in the n heating stages, a temperature difference between any two adjacent heat treatment stages is within a range of 10~150 °C, wherein specifically, the temperature difference may be 15 °C, 20 °C, 30 °C, 40 °C, 50 °C, 60 °C, 70 °C, 80 °C, 90 °C, 100 °C, 110 °C, 120 °C, 130 °C or 140 °C, etc. Optionally, in the m cooling stages, a temperature difference between any two adjacent heat treatment stages is within a range of 10~150 °C, wherein specifically, the temperature difference may be 15 °C, 20 °C, 30 °C, 40 °C, 50 °C, 60 °C, 70 °C, 80 °C, 90 °C, 100 °C, 110 °C, 120 °C, 130 °C or 140 °C, etc.

In some embodiments, the glass raw sheet is lithium-aluminum-silicate glass. Preferably, the glass contains the following components (mol%): $SiO_2$ 65-72% (for example, 66%, 67%, 68%, 69%, 70% or 71%), $Al_2O_3$ 3-7% (for example, 3.5%, 4%, 4.5%, 5%, 5.5%, 6% or 6.5%), $ZrO_2$ 0.5-5% (for example, 1%, 1.5%, 2%, 2.5%, 3%, 3.5%, 4% or 4.5%), $Li_2O$ 15-25% (for example, 16%, 17%, 18%, 19%, 20%, 21%, 22%, 23% or 24%), $Na_2O$ 0-2% (for example, 0.1%, 0.8%, 1%, 1.2%, 1.5%, 1.8% or 1.9%), $P_2O_5$ 0.5-2% (for example, 0.7%, 0.9%, 1%, 1.2%, 1.5%, 1.8% or 1.9%), $B_2O_3$ 0-2% (for example, 0.1%, 0.5%, 1%, 1.2%, 1.5%, 1.8% or 1.9%), MgO 0-3% (for example, 0.1%, 0.5%, 0.7%, 0.9%, 1%, 1.2%, 1.5%, 1.8%, 2.4%, 2.7% or 2.9%), ZnO 0-3% (for example, 0.1%, 0.3%, 0.6%, 0.9%, 1%, 1.2%, 1.5%, 1.8%, 2%, 2.5% or 2.7%).

The present disclosure further provides microcrystalline glass prepared by the above method, wherein an XRD diffraction peak height H of the microcrystalline glass is greater than or equal to 870, preferably 960-1150, and further preferably 980~1132.

Preferably, b value of the microcrystalline glass is less than or equal to 0.4; and specifically, the b value may be 0.39, 0.38, 0.37, 0.36, 0.35, 0.34, 0.33, 0.32, 0.31 or 0.3, etc.

Preferably, in the microcrystalline glass, a content of lithium disilicate and petalite is 90-100%; and specifically, the content may be 91%, 93%, 94%, 95%, 97% or 99%, etc.

Preferably, in the microcrystalline glass, a content of crystalline phases of lithium silicate and β-quartz is 0-10%, wherein preferably, the content is less than or equal to 5; and further preferably, the content is 0.

The present disclosure further provides a use of microcrystalline glass prepared by the above method, wherein the microcrystalline glass is used as any one of a mobile phone cover plate, a tablet computer cover plate, a watch cover plate, and an automobile display cover plate.

**Examples**

In order to further clearly illustrate and explain the technical solutions of the present disclosure, non-limiting examples are provided below.

Glass raw materials were blended, so as to obtain glass expressed by mol% of oxides in Table 1. After the mixing, melting and molding were performed, wherein molding methods include a float method, overflowing, rolling, casting, etc. A molded glass plate was annealed, and then cut and polished, so as to obtain glass raw sheets with the same size. The prepared glass raw sheets each had a thickness of 0.58 mm±0.02 mm.

A glass transition temperature $T_g$ in Table 1 was evaluated by a following method:

a differential thermal analysis method was used to obtain a glass DSC curve. A temperature corresponding to a first exothermic peak starting point on this curve is just the glass transition temperature Tg.

Table 1

| Component (mol%) / Glass No. | $SiO_2$ | $Al_2O_3$ | $P_2O_5$ | $ZrO_2$ | MgO | ZnO | $Na_2O$ | $Li_2O$ | $B_2O_3$ | $T_g$ |
|---|---|---|---|---|---|---|---|---|---|---|
| Glass 1 | 65.0% | 3.0% | 1.5% | 2.0% | 1.3% | 1.2% | 0.5% | 25.0% | 0.5% | 536 |
| Glass 2 | 69.0% | 4.0% | 0.8% | 1.7% | 1.0% | 1.0% | 0.0% | 21.0% | 1.5% | 540 |
| Glass 3 | 72.0% | 3.5% | 1.0% | 0.5% | 0.8% | 0.0% | 0.7% | 19.5% | 2.0% | 542 |
| Glass 4 | 70.0% | 3.0% | 2.0% | 4.5% | 0.0% | 3.0% | 2.0% | 15.4% | 0.1% | 540 |
| Glass 5 | 67.0% | 7.0% | 1.5% | 0.8% | 2.8% | 2.1% | 1.0% | 17.1% | 0.7% | 538 |

The obtained glass raw sheets were treated under conditions described in Tables 2-5. In columns of crystallization process in the tables, a magnitude of $\Delta T_1$ is described, wherein a crystallization temperature in specific implementation is $T_g+\Delta T_1$. In columns of heat treatment process in the tables, heat treatment regimens for glass 1 to glass 5 are described, wherein a magnitude of $\Delta T2$ is equal to a highest heat treatment temperature in high-temperature stage minus the glass transition temperature $T_g$. In columns of crystal content in Tables 2-5, letters A, B, C, and D respectively represent crystalline phases of petalite, lithium disilicate, lithium silicate, and quartz. Meanwhile, the crystal content in Tables 2-5 represents a proportion of a mass of crystals indicated to a total mass of crystals in the glass.

A diffraction peak height, precipitated crystals, and b value of the glass in Tables 2-5 were evaluated by following methods:

1. b value of the glass: The crystallized glass sheets were cleaned in an ultrasonic cleaning machine, wherein cleaning conditions include: cleaning duration: 5-10 min; cleaning agent used: a commonly used detergent diluted 10 times; cleaning temperature: 45 °C-65 °C; cleaning frequency: 20 KHZ-40 KHZ. Then, transmittance of the glass under different wavelengths was tested using a haze meter, and the b value of the glass was tested according to the standard "GBIT 7962.12-2010 Test methods of colourless optical glass - Part 12: Spectral internal transmittance". The haze meter used in the present disclosure is Japanese Konica Minolta spectrophotometer CM-3600A.

2. Diffraction peak height: The crystalized microcrystalline glass sheets were ground by a pulverizer into fine glass powders, with a particle size less than 75 μm, and then the powders were tested by an X-ray diffractometer, so as to obtain an XRD diffraction peak curve. Then JADE software was used to obtain the XRD diffraction peak height of the glass.

The X-ray diffractometer used in the present disclosure is Shimadzu XRD-6100, and a range of incident angle used for test is 2 Theta=10-80°, a scan speed is 6°/min, a working voltage is 40 KV, and a working current is 30 KA.

3. Precipitation of crystals:

The crystalline phases contained in the microcrystalline glass were analyzed using JCPDS card database in the JADE software.

Table 2 Examples 1-10

| | | 1 | 2 | 3 | 4 | 5 | 6 | 7 | 8 | 9 | 10 |
|---|---|---|---|---|---|---|---|---|---|---|---|
| Glass No. | | Glass 1 | Glass 1 | Glass 1 | Glass 1 | Glass 1 | Glass 1 | Glass 1 | Glass 1 | Glass 2 | Glass 2 |
| Nucleation | Nucleation Temperatu re/ °-C | 565 | 565 | 565 | 565 | 565 | 565 | 565 | 565 | 560 | 560 |
| | Nucleation Duration/ min | 240 | 240 | 240 | 240 | 240 | 240 | 240 | 240 | 180 | 180 |
| Crystalliz ation | $\triangle T_1$ o/C | 117 | 117 | 117 | 117 | 117 | 117 | 120 | 126 | 123 | 123 |
| | Crystalliza tion Duration/ min | 100 | 100 | 100 | 100 | 100 | 100 | 100 | 100 | 120 | 120 |
| XRD Highest Diffraction Peak Height H after Crystallization | | 376 | 376 | 376 | 376 | 376 | 376 | 437 | 686 | 533 | 533 |
| Heat Treatme nt | $T_{N1}$/oC | 450 | 450 | 450 | 450 | 450 | 450 | 450 | 450 | 450 | 450 |
| | $t_{N1}$/s | 30 | 30 | 30 | 30 | 30 | 30 | 30 | 30 | 30 | 30 |
| | $T_{N2}$/oC | 600 | 600 | 600 | 600 | 600 | 600 | 600 | 600 | 600 | 600 |
| | $t_{N2}$/s | 10 | 10 | 10 | 10 | 10 | 10 | 10 | 10 | 60 | 60 |
| | $T_{N3}$/oC | 620 | 620 | 620 | 620 | 620 | 620 | 620 | 620 | 620 | 620 |
| | $t_{N3}$/s | 60 | 60 | 60 | 60 | 60 | 60 | 60 | 60 | 60 | 60 |
| | $T_{N4}$/oC | 640 | 640 | 640 | 640 | 640 | 640 | 640 | 640 | - | - |
| | $t_{N4}$/s | 60 | 60 | 60 | 60 | 60 | 60 | 60 | 60 | - | - |
| | $T_{K1}$/oC | 730 | 720 | 710 | 700 | 690 | 680 | 730 | 710 | 720 | 710 |
| | $t_{k1}$/s | 90 | 90 | 90 | 90 | 90 | 90 | 90 | 90 | 90 | 90 |

(continued)

| | | 1 | 2 | 3 | 4 | 5 | 6 | 7 | 8 | 9 | 10 |
|---|---|---|---|---|---|---|---|---|---|---|---|
| | $T_{K2}$/ºC | 750 | 740 | 730 | 720 | 710 | 700 | 750 | 730 | 740 | 730 |
| | $t_{k2}$/s | 90 | 90 | 90 | 90 | 90 | 90 | 90 | 90 | 90 | 90 |
| | $T_{K3}$/ºC | 760 | 750 | 740 | 730 | 720 | 710 | 760 | 740 | 760 | 750 |
| | $t_{k3}$/s | 90 | 90 | 90 | 90 | 90 | 90 | 90 | 90 | 90 | 90 |
| | $T_{K4}$/ºC | 710 | 700 | 690 | 680 | 670 | 660 | 710 | 690 | - | - |
| | $t_{k4}$/s | 90 | 90 | 90 | 90 | 90 | 90 | 90 | 90 | - | - |
| | $T_{M1}$/ºC | 600 | 600 | 600 | 600 | 600 | 600 | 600 | 600 | 620 | 620 |
| | $t_{m1}$/s | 60 | 60 | 60 | 60 | 60 | 60 | 60 | 60 | 60 | 60 |
| | $T_{M2}$/ºC | 550 | 550 | 550 | 550 | 550 | 550 | 550 | 550 | 460 | 460 |
| | $t_{m2}$/s | 40 | 40 | 40 | 40 | 40 | 40 | 40 | 40 | 40 | 40 |
| | $T_{M3}$/ºC | 400 | 400 | 400 | 400 | 400 | 400 | 400 | 400 | 300 | 300 |
| | $t_{m3}$/s | 30 | 30 | 30 | 30 | 30 | 30 | 30 | 30 | 30 | 30 |
| | $T_{M4}$/ºC | 300 | 300 | 300 | 300 | 300 | 300 | 300 | 300 | - | - |
| | $t_{m4}$/s | 30 | 30 | 30 | 30 | 30 | 30 | 30 | 30 | - | - |
| | $\triangle T_2$/ºC | 224 | 214 | 204 | 194 | 184 | 174 | 224 | 204 | 220 | 210 |
| XRD Highest Diffraction Peak Height H after Heat Treatment | | 115 5 | 113 2 | 105 4 | 101 5 | 990 | 955 | 115 5 | 105 4 | 116 0 | 112 5 |
| Crystalline Phase | | A+B+C | A+ B | A+ B | A+ B | A+ B | A+B+C | A+B+C | A+ B | A+B+C | A+ B |
| A+B Crystal Content | | 97% | 100 % | 100 % | 100 % | 100 % | 98% | 97% | 100 % | 96.5 % | 100 % |
| C+D Crystalline Phase Content | | 3% | 0% | 0% | 0% | 0% | 2% | 3% | 0% | 3.5 % | 0% |
| b Value of Glass | | 0.43 | 0.4 0 | 0.3 4 | 0.3 5 | 0.3 6 | 0.38 | 0.43 | 0.3 4 | 0.42 | 0.3 8 |

Table 3 Examples 11-20

| | | 11 | 12 | 13 | 14 | 15 | 16 | 17 | 18 | 19 | 20 |
|---|---|---|---|---|---|---|---|---|---|---|---|
| Glass No. | | Gla ss 2 | Gla ss 2 | Gla ss 2 | Gla ss 2 | Glass s2 | Gla ss 2 | Glass s3 | Gla ss 3 | Gla ss 3 | Gla ss 3 |
| Nucleatio n | Nucleatio n Temperat ure /ºC | 560 | 560 | 560 | 560 | 560 | 560 | 558 | 558 | 558 | 558 |
| | Nucleatio n Duration/ min | 180 | 180 | 180 | 180 | 180 | 180 | 300 | 300 | 300 | 300 |
| Crystalliz ation | $\triangle T_1$º/C | 123 | 123 | 123 | 123 | 126 | 133 | 115 | 115 | 115 | 115 |
| | Crystalliz ation Duration/ min | 120 | 120 | 120 | 120 | 120 | 120 | 80 | 80 | 80 | 80 |
| XRD Highest Diffraction Peak Height H after Crystallization | | 533 | 533 | 533 | 533 | 665 | 831 | 338 | 338 | 338 | 338 |

(continued)

| | | 11 | 12 | 13 | 14 | 15 | 16 | 17 | 18 | 19 | 20 |
|---|---|---|---|---|---|---|---|---|---|---|---|
| Heat Treatmen t | $T_{N1}$/ºC | 450 | 450 | 450 | 450 | 450 | 450 | 450 | 450 | 450 | 450 |
| | $t_{N1}$/s | 30 | 30 | 30 | 30 | 30 | 30 | 30 | 30 | 30 | 30 |
| | $T_{N2}$/ºC | 600 | 600 | 600 | 600 | 600 | 600 | 600 | 600 | 600 | 600 |
| | $t_{N2}$/s | 60 | 60 | 60 | 60 | 60 | 60 | 60 | 60 | 60 | 60 |
| | $T_{N3}$/ºC | 620 | 620 | 620 | 620 | 620 | 620 | 650 | 650 | 650 | 650 |
| | $t_{N3}$/s | 60 | 60 | 60 | 60 | 60 | 60 | 90 | 90 | 90 | 90 |
| | $T_{N4}$/ºC | - - | - | - | - | - | - | - | - | - | - |
| | $t_{N4}$/s | - | - | - | - | - | z | - | - | - | - |
| | $T_{K1}$/ºC | 700 | 690 | 680 | 670 | 720 | 690 | 730 | 720 | 710 | 700 |
| | $t_{k1}$/s | 90 | 90 | 90 | 90 | 90 | 90 | 90 | 90 | 90 | 90 |
| | $T_{K2}$/ºC | 720 | 710 | 700 | 690 | 740 | 710 | 750 | 740 | 730 | 720 |
| | $t_{k2}$/s | 90 | 90 | 90 | 90 | 90 | 90 | 90 | 90 | 90 | 90 |
| | $T_{K3}$/ºC | 740 | 730 | 720 | 710 | 760 | 730 | 765 | 755 | 745 | 735 |
| | $t_{k3}$/s | 90 | 90 | 90 | 90 | 90 | 60 | 90 | 90 | 90 | 90 |
| | $T_{K4}$/ºC | - | - | - | - | - | - | - | - | - | - |
| | $t_{k4}$/s | - | - | - | - | - | - | - | - | - | - |
| | $T_{M1}$/ºC | 620 | 620 | 620 | 620 | 620 | 620 | 600 | 600 | 600 | 600 |
| | $t_{m1}$/s | 60 | 60 | 60 | 60 | 60 | 60 | 90 | 90 | 90 | 90 |
| | $T_{M2}$/ºC | 460 | 460 | 460 | 460 | 460 | 460 | 450 | 450 | 450 | 450 |
| | $t_{m2}$/s | 40 | 40 | 40 | 40 | 40 | 40 | 60 | 60 | 60 | 60 |
| | $T_{M3}$/ºC | 300 | 300 | 300 | 300 | 300 | 300 | 300 | 300 | 300 | 300 |
| | $t_{m3}$/s | 30 | 30 | 30 | 30 | 30 | 30 | 30 | 30 | 30 | 30 |
| | $T_{M4}$/ºC | - | - | - | - | - | - | - | - | - | - |
| | $t_{m4}$/s | - | - | - | - | - | - | - | - | - | - |
| | $\triangle T_2$/ºC | 200 | 190 | 180 | 170 | 220 | 190 | 223 | 213 | 203 | 193 |
| XRD Highest Diffraction Peak Height H after Heat Treatment | | 1045 | 1015 | 995 | 960 | 1160 | 1015 | 1167 | 1125 | 1050 | 1007 |
| Crystalline Phase | | A+ B | A+ B | A+ B | A+ B | A+B +C | A+ B | A+B +C | A+ B | A+ B | A+ B |
| A+B Crystal Content | | 100 % | 100 % | 100 % | 100 % | 96.5 % | 100 % | 92% | 100 % | 100 % | 100 % |
| C+D Crystalline Phase Content | | 0% | 0% | 0% | 0% | 3.5% | 0% | 8% | 0% | 0% | 0% |
| b Value of Glass | | 0.3 3 | 0.3 5 | 0.3 6 | 0.3 9 | 0.42 | 0.3 5 | 0.44 | 0.4 0 | 0.3 3 | 0.3 6 |

Table 4 Examples 21-30

| | | 21 | 22 | 23 | 24 | 25 | 26 | 27 | 28 | 29 | 30 |
|---|---|---|---|---|---|---|---|---|---|---|---|
| Glass No. | | Glass 3 | Glass 3 | Glass 3 | Glass 3 | Glass 4 | Glass 4 | Glass 4 | Glass 4 | Glass 4 | Glass 4 |
| Nucleation | Nucleation Temperature /ºC | 558 | 558 | 558 | 558 | 558 | 558 | 558 | 558 | 558 | 558 |
| | Nucleation Duration/min | 300 | 300 | 300 | 300 | 200 | 200 | 200 | 200 | 200 | 200 |
| Crystallization | $\Delta T_1$ºC | 115 | 115 | 123 | 120 | 119 | 119 | 119 | 119 | 119 | 119 |
| | Crystallization Duration/min | 80 | 80 | 80 | 80 | 130 | 130 | 130 | 130 | 130 | 130 |
| XRD Highest Diffraction Peak Height H after Crystallization | | 338 | 338 | 391 | 508 | 403 | 403 | 403 | 403 | 403 | 403 |
| Heat Treatment | $T_{N1}$/ºC | 450 | 450 | 450 | 450 | 460 | 460 | 460 | 460 | 460 | 460 |
| | $t_{N1}$/s | 30 | 30 | 30 | 30 | 30 | 30 | 30 | 30 | 30 | 30 |
| | $T_{N2}$/ºC | 600 | 600 | 600 | 600 | 610 | 610 | 610 | 610 | 610 | 610 |
| | $t_{N2}$/s | 60 | 60 | 60 | 60 | 60 | 60 | 60 | 60 | 60 | 60 |
| | $T_{N3}$/ºC | 650 | 650 | 650 | 650 | - | - | - | - | - | - |
| | $t_{N3}$/s | 90 | 90 | 90 | 90 | - | - | - | - | - | - |
| | $T_{K1}$/ºC | 690 | 680 | 720 | 700 | 730 | 720 | 710 | 700 | 690 | 680 |
| | $t_{k1}$/s | 90 | 90 | 90 | 90 | 90 | 90 | 90 | 90 | 90 | 90 |
| | $T_{K2}$/ºC | 710 | 700 | 740 | 720 | 750 | 740 | 730 | 720 | 710 | 700 |
| | $t_{k2}$/s | 90 | 90 | 90 | 90 | 90 | 90 | 90 | 90 | 90 | 90 |
| | $T_{K3}$/ºC | 725 | 715 | 755 | 735 | 760 | 750 | 740 | 730 | 720 | 710 |
| | $t_{k3}$/s | 90 | 90 | 90 | 90 | 90 | 90 | 90 | 90 | 90 | 90 |
| | $T_{M1}$/ºC | 600 | 600 | 600 | 600 | 600 | 600 | 600 | 600 | 600 | 600 |
| | $t_{m1}$/s | 90 | 90 | 90 | 90 | 60 | 60 | 60 | 60 | 60 | 60 |
| | $T_{M2}$/ºC | 450 | 450 | 450 | 450 | 450 | 450 | 450 | 450 | 450 | 450 |
| | $t_{m2}$/s | 60 | 60 | 60 | 60 | 40 | 40 | 40 | 40 | 40 | 40 |
| | $T_{M3}$/ºC | 300 | 300 | 300 | 300 | 300 | 300 | 300 | 300 | 300 | 300 |
| | $t_{m3}$/s | 30 | 30 | 30 | 30 | 30 | 30 | 30 | 30 | 30 | 30 |
| | $\Delta T_2$/ºC | 183 | 173 | 213 | 193 | 220 | 210 | 200 | 190 | 180 | 170 |
| XRD Highest Diffraction Peak Height H after Heat Treatment | | 985 | 962 | 1125 | 1007 | 1163 | 1129 | 1058 | 1000 | 995 | 971 |
| Crystalline Phase | | A+B | A+B+C | A+B | A+B | A+B+C+D | A+B | A+B | A+B | A+B | A+B+C |
| A+B Crystal Content | | 100% | 99.5 % | 100% | 100% | 94.5 % | 100% | 100% | 100% | 100% | 99% |
| C+D Crystalline Phase Content | | 0% | 0.5% | 0% | 0% | 5.4% | 0% | 0% | 0% | 0% | 1% |
| b Value of Glass | | 0.37 | 0.39 | 0.40 | 0.36 | 0.42 | 0.39 | 0.35 | 0.36 | 0.36 | 0.38 |

Table 5 Examples 31-40

| | | 31 | 32 | 33 | 34 | 35 | 36 | 37 | 38 | 39 | 40 |
|---|---|---|---|---|---|---|---|---|---|---|---|
| Glass No. | | Glass 4 | Glass 4 | Glass 5 | Glass 5 | Glass 5 | Glass 5 | Glass 5 | Glass 5 | Glass 5 | Glass 5 |
| Nucleation | Nucleation Temperature/$^{\circ}$C | 558 | 558 | 562 | 562 | 562 | 562 | 562 | 562 | 562 | 562 |
| | Nucleation Duration/min | 200 | 200 | 250 | 250 | 250 | 250 | 250 | 250 | 280 | 220 |
| Crystallization | $\Delta T_1$/$^{\circ}$C | 122 | 117 | 122 | 122 | 122 | 122 | 122 | 122 | 125 | 120 |
| | Crystallization Duration/min | 130 | 130 | 85 | 85 | 85 | 85 | 85 | 85 | 85 | 85 |
| XRD Highest Diffraction Peak Height H after Crystallization | | 505 | 370 | 493 | 493 | 493 | 493 | 493 | 493 | 626 | 419 |
| Heat Treatment | $T_{N1}$/$^{\circ}$C | 460 | 460 | 450 | 450 | 450 | 450 | 450 | 450 | 450 | 450 |
| | $t_{N1}$/s | 30 | 30 | 30 | 30 | 30 | 30 | 30 | 30 | 30 | 30 |
| | $T_{N2}$/$^{\circ}$C | 610 | 610 | 600 | 600 | 600 | 600 | 600 | 600 | 600 | 600 |
| | $t_{N2}$/s | 60 | 60 | 30 | 30 | 30 | 30 | 30 | 30 | 30 | 30 |
| | $T_{N3}$/$^{\circ}$C | - | - | 620 | 620 | 620 | 620 | 620 | 620 | 620 | 620 |
| | $t_{N3}$/s | - | - | 30 | 30 | 30 | 30 | 30 | 30 | 30 | 30 |
| | $T_{K1}$/$^{\circ}$C | 720 | 730 | 725 | 715 | 705 | 695 | 685 | 675 | 675 | 705 |
| | $t_{k1}$/s | 90 | 90 | 90 | 90 | 90 | 90 | 90 | 90 | 90 | 90 |
| | $T_{K2}$/$^{\circ}$C | 740 | 750 | 750 | 740 | 730 | 720 | 710 | 700 | 700 | 730 |
| | $t_{k2}$/s | 90 | 90 | 90 | 90 | 90 | 90 | 90 | 90 | 90 | 90 |
| | $T_{K3}$/$^{\circ}$C | 750 | 760 | 760 | 750 | 740 | 730 | 720 | 710 | 710 | 740 |
| | $t_{k3}$/s | 90 | 90 | 90 | 90 | 90 | 90 | 90 | 90 | 90 | 90 |
| | $T_{M1}$/$^{\circ}$C | 600 | 600 | 660 | 660 | 660 | 660 | 660 | 660 | 660 | 660 |
| | $t_{m1}$/s | 60 | 60 | 90 | 90 | 90 | 90 | 90 | 90 | 90 | 90 |
| | $T_{M2}$/$^{\circ}$C | 450 | 450 | 600 | 600 | 600 | 600 | 600 | 600 | 600 | 600 |
| | $t_{m2}$/s | 40 | 40 | 60 | 60 | 60 | 60 | 60 | 60 | 60 | 60 |
| | $T_{M3}$/$^{\circ}$C | 300 | 300 | 450 | 450 | 450 | 450 | 450 | 450 | 450 | 450 |
| | $T_{N1}$/$^{\circ}$C | 30 | 30 | 40 | 40 | 40 | 40 | 40 | 40 | 40 | 40 |
| | $T_{M4}$/$^{\circ}$C | - | - | 300 | 300 | 300 | 300 | 300 | 300 | 300 | 300 |
| | $t_{m4}$/s | - | - | 30 | 30 | 30 | 30 | 30 | 30 | 30 | 30 |
| | $\Delta T_2$/$^{\circ}$C | 210 | 220 | 222 | 212 | 202 | 192 | 182 | 172 | 172 | 202 |
| XRD Highest Diffraction Peak Height H after Heat Treatment | | 1130 | 1163 | 1158 | 1127 | 1052 | 1010 | 985 | 970 | 970 | 1052 |
| Crystalline Phase | | A+B | A+B+C+D | A+B+C | A+B | A+B | A+B | A+B | A+B | A+B | A+B |

(continued)

|  | 31 | 32 | 33 | 34 | 35 | 36 | 37 | 38 | 39 | 40 |
|---|---|---|---|---|---|---|---|---|---|---|
| A+B Crystal Content | 100% | 94.5 % | 97.5 % | 100% | 100% | 100% | 100% | 100% | 100% | 100% |
| C+D Crystalline Phase Content | 0% | 5.4% | 2.5% | 0% | 0% | 0% | 0% | 0% | 0% | 0% |
| b Value of Glass | 0.39 | 0.42 | 0.42 | 0.38 | 0.34 | 0.36 | 0.37 | 0.38 | 0.38 | 0.34 |

Performance test result is described as follows.

In Examples 1-8, the glass raw sheets of the glass 1 were treated under different crystallization and heat treatment processes. In the above, Examples 1-6 had the same nucleation and crystallization processes and different heat treatment processes. The heat treatment processes mainly differed in that heat treatment temperatures in the high-temperature stages were different, that is, $\Delta T_2$ was different, wherein $\Delta T_2$ in Example 1 was the highest, the XRD highest diffraction peak height H after corresponding heat treatment was also the highest, reaching 1155, crystalline phases of the obtained glass contained lithium silicate appearing due to excessive crystallization, and the b value of the glass was 0.43, thus the optical performance was poor compared with several other examples. In addition, the diffraction peak height H in Example 6 was the lowest, and although the crystalline phases contained incompletely crystallized lithium silicate, etc., with a content of 2%, the b value of the glass was 0.38. It can be seen from comparison of Examples 1, 7, and 8 that under the same nucleation process, with the increase of the crystallization temperature, the XRD highest diffraction peak height H after the crystallization also increases.

In Examples 9-16, the glass raw sheets of the glass 2 were treated under different heat treatment processes. The heat treatment processes mainly differed in different $\Delta T_2$, wherein $\Delta T_2$ and the diffraction peak height H in Example 9 were the highest, lithium silicate also appeared in the crystalline phases, the b value of the glass exceeded 0.4, and thus the optical performance was poor compared with several other examples.

In Examples 17-22, the glass raw sheets of the glass 3 were treated under different heat treatment processes. The heat treatment processes mainly differed in different $\Delta T_2$, wherein $\Delta T_2$ and the diffraction peak height H in Example 17 were the highest, lithium silicate also appeared in the crystalline phases, and thus the optical performance was poor compared with several other examples.

In Examples 25-30, the glass raw sheets of the glass 4 were treated under different heat treatment processes. The heat treatment processes mainly differed in different $\Delta T_2$, wherein $\Delta T_2$ and the diffraction peak height H in Example 25 were the highest, lithium silicate also appeared in the crystalline phases, and thus the optical performance was poor compared with several other examples. Besides, $\Delta T_2$ and the diffraction peak height H in Example 30 were the lowest compared with several other examples, a content of residual incompletely crystallized lithium silicate in the crystalline phases was high and reached 1%, and the b value of the obtained glass was 0.38.

In Examples 33-38, the glass raw sheets of the glass 5 were treated under different heat treatment processes. The heat treatment processes mainly differed in different $\Delta T_2$, wherein $\Delta T_2$ and the diffraction peak height H in Example 33 were the highest, lithium silicate also appeared in the crystalline phases, and thus the optical performance was poor compared with several other examples.

The above are only embodiments of the present disclosure, and do not limit the patent scope of the present disclosure. All equivalent structure or equivalent flow transformations made by utilizing the contents of the description and the drawing of the present disclosure, which are directly or indirectly applied to other related technical fields, are similarly included in the scope of protection of the present disclosure.

**Claims**

1. A preparation method for transparent microcrystalline glass, wherein the method comprises steps of:

   (1) performing nucleation on a glass raw sheet;
   (2) performing crystallization on the nucleated glass raw sheet; and
   (3) performing a heat treatment on the crystallized glass sheet, so as to obtain the microcrystalline glass with an XRD diffraction peak height H of $\geq 870$,
   wherein the heat treatment is divided into a heating stage, a high-temperature stage and a cooling stage, wherein the heating stage is divided into n heating stages, the high-temperature stage is divided into k high-temperature stages, and the cooling stage is divided into m cooling stages, wherein k is an integer obtained by rounding (n+k+m)/3, and $6 \geq n+k+m \geq 30$;
   each of the high-temperature stages has a constant temperature $T_{Ki}$, where i=1, 2, 3...;

a maximum value of the constant temperature $T_{Ki}$ in the k high-temperature stages is $T_{Kmax}$, and $T_{Kmax}=Tg+\Delta T_2$, wherein the $T_g$ is a glass transition point temperature of the glass raw sheet,
wherein the $\Delta T_2$ satisfies a formula of:

$H=(965.522\pm21.205)+(0.816\pm1.876)|(Tg+\Delta T2)-(715.212\pm5.120)|^\wedge(1.465\pm0.566);$
and
in the k high-temperature stages, a temperature difference between any two adjacent heat treatment stages is within a range of 5-50 °C.

2. The preparation method according to claim 1, wherein a temperature of the nucleation is $T_g+10$ °C~$T_g+80$ °C, and a duration of the nucleation is 120~360 min.

3. The preparation method according to claim 1 or 2, wherein a temperature of the crystallization is $T_g+\Delta T_1$, and a duration of the crystallization is 30~150 min, wherein 100 °C$\leq\Delta T_1\leq$150 °C.

4. The preparation method according to any one of claims 1 to 3, wherein the XRD diffraction peak height H of the microcrystalline glass is 960~1150.

5. The preparation method according to any one of claims 1 to 4, wherein processing durations of the k high-temperature stages, the n heating stages and the m cooling stages are each independently selected from 10~90 s.

6. The preparation method according to any one of claims 1 to 5, wherein in the n heating stages, a temperature difference between any two adjacent heat treatment stages is within a range of 10~150 °C; and
optionally, in the m cooling stages, a temperature difference between any two adjacent heat treatment stages is within a range of 10~150 °C.

7. The preparation method according to any one of claims 1 to 6, wherein in the k high-temperature stages, a temperature difference between any two adjacent heat treatment stages is within a range of 5~30 °C, and preferably, the temperature difference is within a range of 10~20 °C.

8. The preparation method according to any one of claims 1 to 6, wherein the glass raw sheet is lithium-aluminum-silicate glass; and
preferably, the glass raw sheet contains following components in mol%:

| | |
|---|---|
| $SiO_2$ | 65~72 |
| $Al_2O_3$ | 3~7 |
| $ZrO_2$ | 0.5~5 |
| $Li_2O$ | 15~25 |
| $Na_2O$ | 0~2 |
| $P_2O_5$ | 0.5~2 |
| $B_2O_3$ | 0~2 |
| MgO | 0~3 |
| ZnO | 0~3. |

9. Microcrystalline glass prepared by the method according to any one of claims 1 to 8, wherein an XRD diffraction peak height H of the microcrystalline glass is greater than or equal to 870, H is preferably 960-1150, and further preferably 980-1132;
preferably, b value of the microcrystalline glass is less than or equal to 0.4;

preferably, in the microcrystalline glass, a content of lithium disilicate and petalite is 90-100%; and
preferably, in the microcrystalline glass, a content of crystalline phases of lithium silicate and β-quartz is 0-10%, wherein preferably, the content of the crystalline phases of lithium silicate and β-quartz is less than or equal to 5; and further preferably, the content of the crystalline phases of lithium silicate and β-quartz is 0.

10. A use of the microcrystalline glass prepared by the method according to any one of claims 1 to 8, wherein the microcrystalline glass is used as any one of a mobile phone cover plate, a tablet computer cover plate, a watch cover plate, and an automobile display cover plate.

FIG. 1

| INTERNATIONAL SEARCH REPORT | International application No. |
|---|---|
| | **PCT/CN2022/110155** |

**A.    CLASSIFICATION OF SUBJECT MATTER**

C03C 10/12(2006.01)i;  C03B 32/02(2006.01)i

According to International Patent Classification (IPC) or to both national classification and IPC

**B.    FIELDS SEARCHED**

Minimum documentation searched (classification system followed by classification symbols)

C03B;C03C

Documentation searched other than minimum documentation to the extent that such documents are included in the fields searched

Electronic data base consulted during the international search (name of data base and, where practicable, search terms used)

CNTXT; CNABS; DWPI; VEN; WPABS; ENTXT; CNKI; ISI: 微晶玻璃, 玻璃陶瓷, 二硅酸锂, 硅酸锂, 锂铝硅酸盐, 核化, 晶化, 热处理, microcrystalline glass, glass ceramic, lithium disilicate, lithium silicate, lithium aluminosilicate, nucleation, crystallization, heat treatment

**C.    DOCUMENTS CONSIDERED TO BE RELEVANT**

| Category* | Citation of document, with indication, where appropriate, of the relevant passages | Relevant to claim No. |
|---|---|---|
| X | CN 112321162 A (CHONGQING XINJING SPECIAL GLASS CO., LTD.) 05 February 2021 (2021-02-05)<br>description, paragraphs 7-54 and 64-69, and tables 1-1 | 1-10 |
| X | CN 111253087 A (CHONGQING CITY LIANGJIANG NEW DISTRICT XIAMEIXI SCIENCE AND TECHNOLOGY PARTNERSHIP ENTERPRISE (LIMITED PARTNERSHIP)) 09 June 2020 (2020-06-09)<br>description, paragraphs 47-59 and 91-127 | 1-10 |
| A | CN 110734226 A (SHENZHEN DONGLIHUA TECHNOLOGY CO., LTD.) 31 January 2020 (2020-01-31)<br>entire document | 1-10 |
| A | JP H0935234 A (NGK INSULATORS, LTD.) 07 February 1997 (1997-02-07)<br>entire document | 1-10 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **14 October 2022** | **01 November 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/110155**

| Patent document cited in search report | | | Publication date (day/month/year) | Patent family member(s) | | | Publication date (day/month/year) |
|---|---|---|---|---|---|---|---|
| CN | 112321162 | A | 05 February 2021 | None | | | |
| CN | 111253087 | A | 09 June 2020 | WO | 2021197145 | A1 | 07 October 2021 |
| CN | 110734226 | A | 31 January 2020 | None | | | |
| JP | H0935234 | A | 07 February 1997 | None | | | |

Form PCT/ISA/210 (patent family annex) (January 2015)